# EUROPEAN PATENT APPLICATION

(11) **EP 2 549 545 A1**
(43) Date of publication of application: **23.01.2013**
(21) Application number: 11755951.8
(22) Date of filing: 12.01.2011
(51) Int. Cl.: H01L 31/04

(54) **THIN-FILM SOLAR CELL AND METHOD FOR MANUFACTURING THE SAME**

(30) Priority: 18.03.2010 JP 2010061883
(71) Applicant: Fuji Electric Co., Ltd., Kawasaki-shi Kanagawa 210-9530 (JP)
(72) Inventor: FUJIKAKE, Shinji, Kawasaki-shi Kanagawa 210-9530 (JP)
(74) Representative: Appelt, Christian W.
(86) International application number: PCT/JP2011/050321
(87) International publication number: WO 2011/114761

(57) **Abstract**

This invention provides a thin film solar cell that can be fabricated by causing selective absorption of light in a lower layer of a photoelectric conversion layer followed by blowing-away, by laser irradiation from the side of a transparent electrode, and a method for manufacturing same. This invention relates to a method for manufacturing a thin film solar cell, which is a substrate type solar cell that has a photoelectric conversion layer 6 combining, in a thickness direction, two or more n, i, p junctions with non-single crystal silicon as main materials thereof, and that includes a metal electrode 3, the photoelectric conversion layer 6, and a transparent electrode 7 stacked in this order on a substrate 1, wherein a top cell 6b which is the photoelectric conversion layer 6 on the side of the transparent electrode 7 and a cell 6a of one or more layers on the side of the metal electrode 3 relative to the top cell 6b, are provided, and the method includes a step of simultaneously removing at least the two or more photoelectric conversion layers 6 (6a, 6b) and the transparent electrode 7, using a laser with a wavelength having selective sensitivity with respect to the cell 6a other than the top cell 6b, from the side of the transparent electrode 7.

## Description

### TECHNICAL FIELD

This invention relates to a method for manufacturing a thin film silicon solar cell with a substrate structure, and to a thin film solar cell formed by this manufacturing method.

### BACKGROUND ART

Thin film solar cells, which are a representative example of a solar cell (photoelectric conversion device) in which a plurality of photoelectric conversion elements formed on the same substrate are connected in series, are regarded as the future mainstream of solar cells due to their thin shape, light weight, low manufacturing costs, and ease of manufacture in large sheets. In addition to supplying electric power, demand is increasing for both commercial and general household applications, in which solar cells are mounted on building roofs, windows and similar for use.
Thin film solar cells, that is, thin film silicon-system solar cells which employ as the main material amorphous silicon (a-Si), amorphous silicon-germanium (a-SiGe) or microcrystalline silicon, are already in the stage of mass production, and at the same time active development is underway aiming at further cost reductions.

As the material of the substrate of a thin film silicon solar cell, glass, plastic film, stainless steel foil, or similar is used. Among these, if glass or plastic film, which are insulators, are used, then there are the advantages that an integrated series-connected structure can be fabricated on the substrate, and that arbitrary high voltages can be realized.

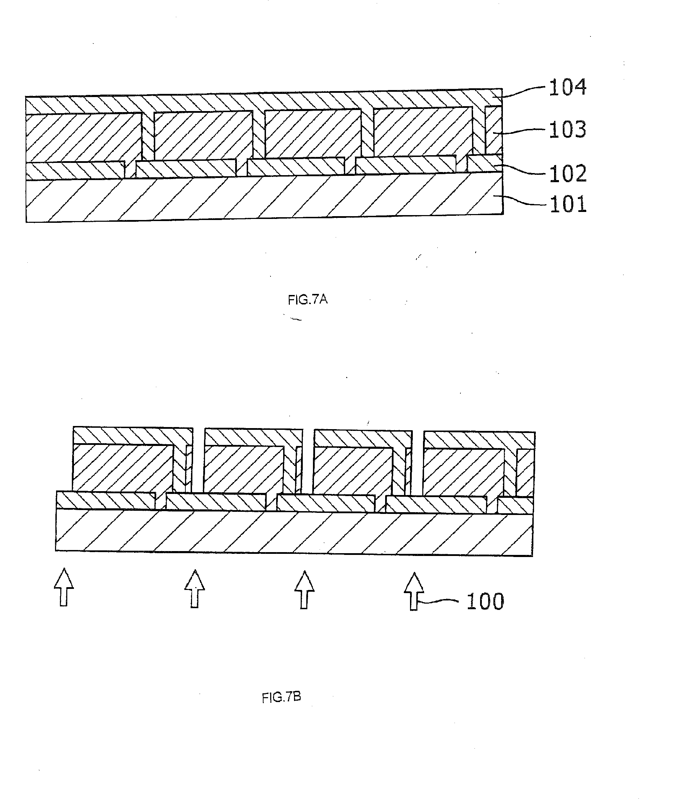

As one example of an integrated type solar cell, Fig. 7 shows the structure of a glass substrate solar cell before and after metal electrode fabrication. Fig. 7A shows the state prior to metal electrode fabrication, and Fig. 7B shows the state after metal electrode fabrication.
A transparent electrode 102, photoelectric conversion layer 103, and metal electrode 104 are formed in this order on a glass substrate 101.
After formation of each of the layers, laser light 100 is used in laser patterning for division into rectangular strips, and series connection is completed.
Here, the laser most widely used in laser patterning is a YAG (yttrium aluminum garnet) laser; the fundamental wave at 1,064 nm is used for fabrication of the transparent electrode 102, and the second harmonic at 532 nm is used for separation of the photoelectric conversion layer 103 and metal electrode 104.

Separation of the transparent electrode 102 and photoelectric conversion layer 103 may be performed from either the side of the glass substrate 101 or the side of the transparent electrode 102, but fabrication of the metal electrode 104, which is the final process, is performed from the side of the glass substrate 101. Upon irradiation with laser light 100 from the side of the glass substrate 101, light absorption occurs in the photoelectric conversion layer 103 comparatively close to the incidence side, and by blowing away the upper layer portion, removal processing is possible.

Further, the fabrication method of simultaneously blowing away the photoelectric conversion layer and metal electrode is difficult for thick film cells of several microns in size, such as tandem cells with microcrystalline silicon. As a means of addressing this, Patent Reference 1 indicates that light in a wavelength band to which microcrystalline silicon is sensitive is used in irradiation from the glass side, and the microcrystalline layer is removed to some degree in advance, after which the second harmonic of the YAG laser is used to remove a-Si.
Here, the wavelength of the laser used to remove microcrystalline silicon is 670 to 900 nm; as the laser, a ruby laser, alexandrite laser, GaAlAs laser, or similar may be used.

On the other hand, with respect to realizing flexibility and lightness of weight in order to enhance freedom of installation on roofs and outer walls, plastic film is preferable to glass substrate, and among these, aramid, polyimide and similar sheets with excellent heat resistance are preferable.
However, because these materials are opaque, a so-called substrate structure, in which a metal electrode, photoelectric conversion layer, and transparent electrode are stacked in this order on a substrate, is employed. Non-patent Reference 1 discloses an example of a thin solar cell employing a substrate-type series-connected structure.

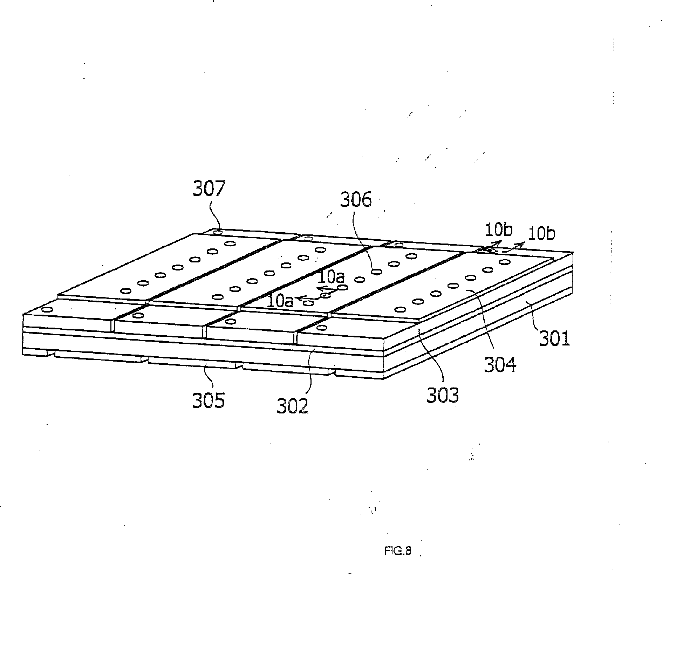

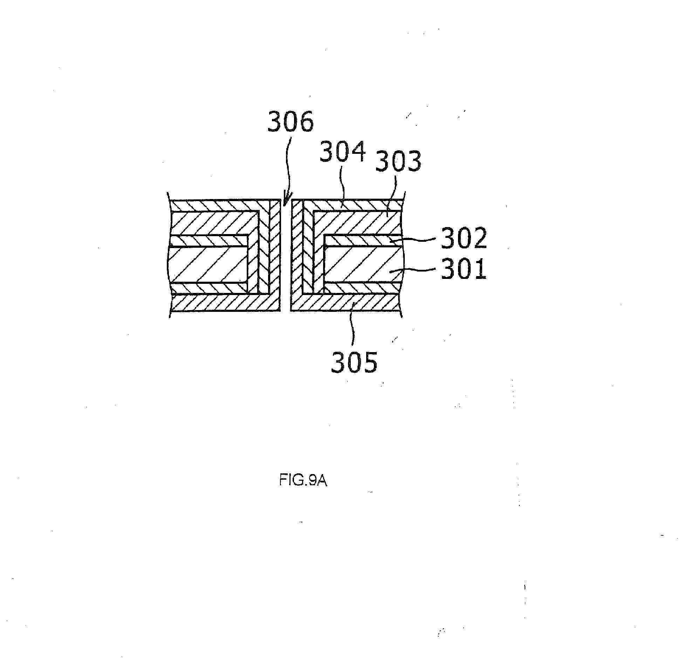

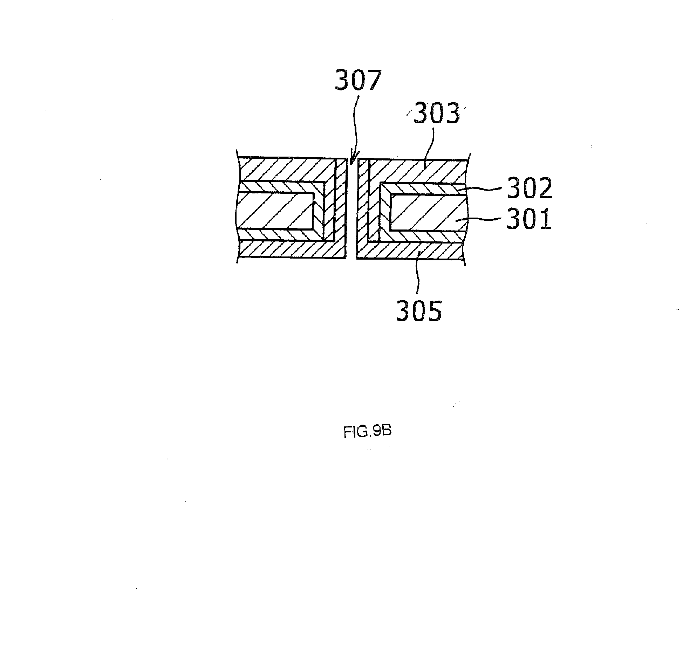

Fig. 8 is a schematic diagram showing the structure of the solar cell of the prior art disclosed in Non-patent Reference 1; Fig. 9A is a cross-sectional view along line 10a-10a in Fig. 8, and Fig. 9B is a cross-sectional view along line 10b-10b in Fig. 8.
The solar cell shown in Fig. 8 has what is called a SCAF (Series-Connection through Apertures on Film) structure in which holes are opened in the film substrate 301, and through-hole contacts are used to form series connections.

In this structure, as shown in Fig. 8, a metal electrode 302, a-Si system film 303 as a photoelectric conversion layer, and transparent electrode 304 are stacked in this order on one of the faces of the film substrate 301. On the other face of the film substrate 301 is formed a back-face electrode 305. The layer formed on the two faces sandwiching this film substrate 301 are each completely by a laser in batch fabrication.

Here, in order to series-connect the metal electrodes 302 and back-face electrodes 305 which have been completely separated and formed on the two faces of the film substrate 301, collector holes 306 and series connection holes 307 are formed (see Fig. 9A and Fig. 9B).
As shown in Fig. 9A, when forming collector holes 306, after depositing the metal electrode 302 on both faces of the film substrate 301, through-holes are opened, and the a-Si system film 303, transparent electrode 304 and back-face electrode 305 are deposited in this order on the exposed end face of the film substrate 301, and the transparent electrode 304 and back-face electrode 305 are connected. On the other hand, as shown in Fig. 9B, when forming the series connection holes 307, the metal electrode 302 is deposited after opening through-holes in the film substrate 301, and the a-Si system film 303 and back-face electrode 305 are deposited in this order, so that the metal electrode 302 on the side of the film substrate 301 on which the a-Si system film 303 is formed is connected to the back-face electrode 305.

For reference, paragraph [0116] of Patent Reference 2 states, using the symbols of this reference, that "the back-face electrode division line 29 can for example be formed by using the second harmonic of a YAG laser to scribe the back-face electrode 11 and the first to third photoelectric conversion layers 5, 7, 9".
Further, paragraph [0038] of Patent Reference 3 states, using the symbols of this reference, that "a transparent electrode layer 112 of SnO₂, having a micro-relief structure on a planar face, was formed by a thermal CVD method. Next, a YAGIR pulse laser was used in laser scanning parallel to the short edge of the substrate, to form grooves 117 of width 40 µm which divided the SnO₂ film 112 into a plurality of strip-shape patterns".

Patent Reference 1: Japanese Patent Application Laid-open No. 2001-267618
Patent Reference 2: Japanese Patent Application Laid-open No. 2009-177225
Patent Reference 3: Japanese Patent Application Laid-open No. 2009-44184
Non-patent Reference 1: Y. Ichikawa, K. Tabuchi, T. Yoshida, S. Kato, A. Takano, S. Saito, H. Sato, S. Fujikake, and H. Sakai: Conference Record 1994 IEEE 1st World Conference on Photovoltaic Energy Conversion (1994), 441.

However, laser fabrication of a substrate type integrated type solar cell, in which n, i and p layers are deposited in this order on a metal reflective substrate, has been extremely difficult compared with superstrate type solar cells such as that shown in Fig. 7.
This is because, in common with both ordinary integrated type structures with the substrate type substituted in Fig. 7 and SCAF cells, it has been difficult to secure insulating properties at end faces after transparent electrode fabrication, particularly in substrate type devices.

First, the principles of fabrication of superstrate type solar cells are explained, and then the difficulty when employing a substrate type structure is explained.

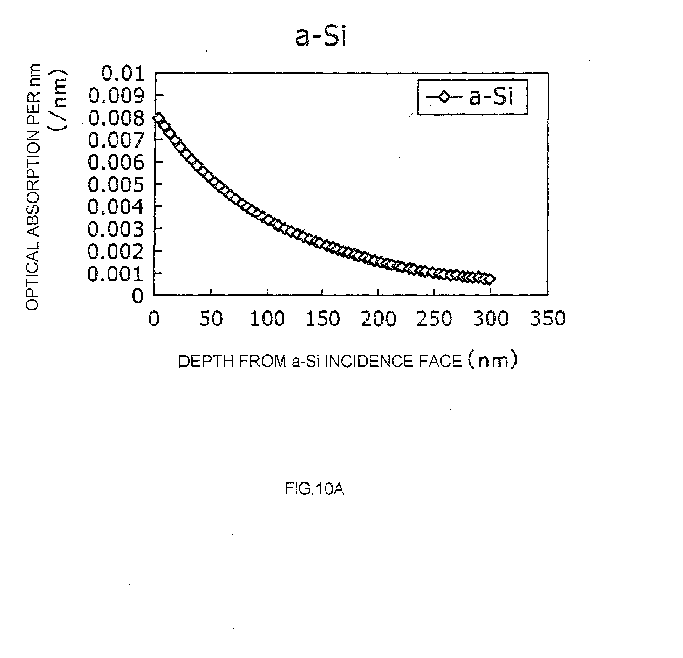

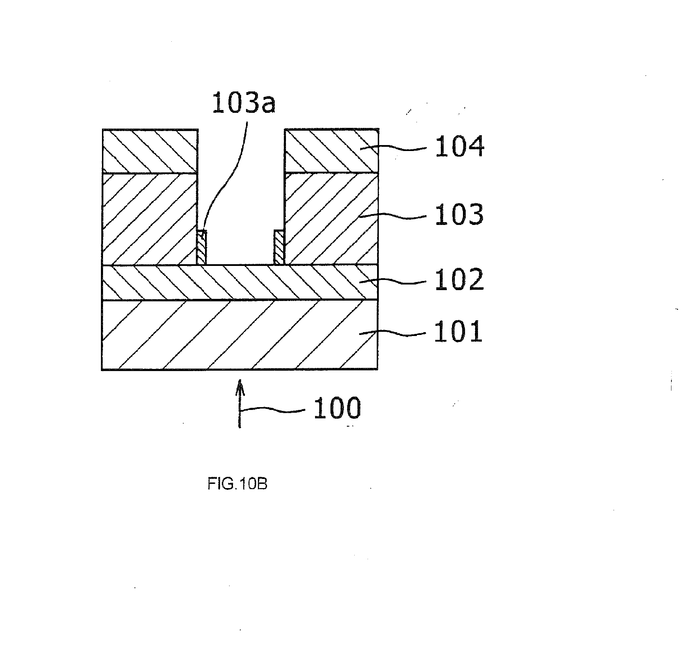

Fig. 10 shows the mechanism of fabrication of superstrate type a-Si solar cells.
Fig. 10A shows a light absorption profile obtained by simulation, and Fig. 10B shows a schematic fabrication cross-section. Ordinarily, when an a-Si system film 103 is laser-processed, a molten crystallized region 103a occurs at the processing end face. This is thought to be true of superstrate type solar cells as well, but because the light absorption profile indicates exponential attenuation, as shown in Fig. 10A, it is thought that the crystallized region 103a occurs on the light incidence side (the lower-layer side), and that crystallization does not occur in regions where removal is by blowing away (the upper-layer side).
As a result, at the end face on the upper-layer side at which a crystallized region 103a does not occur, it is thought that insulation between the transparent electrode 102 and the metal electrode 104 is maintained.

On the other hand, when processing from the transparent electrode side in a substrate type solar cell, the light absorption amount is smaller for the lower layer than for the upper layer, so that blow-away processing cannot be performed. That is, the entirety is caused to absorb light and be removed, so that the entire end face is crystallized, and insulating properties cannot be maintained. In the case of an SCAF structure solar cell, if the three layers of the cell face are batch separation-processed, crystallization of the entire end face occurs, and simultaneously melting and alloying of the metal electrode also occurs, so that it is difficult to secure insulation at the end face.
As a measure to address this problem, a method has been proposed in which, after performing broad-width laser processing of the metal electrode and depositing the photoelectric conversion layer and transparent electrode, narrow-width laser processing is performed; but there are the problems that
(1) one additional process is required; and,
(2) in the second laser processing, positioning is necessary. Particularly in the case of a solar cell using a plastic film substrate, thermal deformation of the film substrate occurs during the heating process, so that the above positioning in (2) is difficult.

### DISCLOSURE OF THE INVENTION

This invention was devised in consideration of such a situation, and has as an object the provision, to resolve such problems, of a thin film solar cell in which, by laser irradiation from the transparent electrode side, light is caused to be selectively absorbed by the lower layer of the photoelectric conversion layer, so that fabrication can be performed by blowing-away, as well as a method for manufacturing such a device.

In the prior art, multijunction cells, which combine a-Si cells and a-SiGe cells or microcrystalline cells with the object of raising the efficiency of the thin film solar cell, have been proposed. Thin film silicon solar cells with this type of substrate structure are configured such that, compared with the photoelectric conversion layer of the top cell, the band gap of the i layer of the bottom cell is smaller.
This invention resolves such problems, and proposes a method and product to utilize the difference in band gaps in the above-described technology of the prior art, and cause light absorption in the bottom cell which is the lower layer.

That is, one aspect of this invention is a method of manufacturing a thin film solar cell, which is a substrate type solar cell that has a photoelectric conversion layer combining, in a thickness direction, two or more n, i, p junctions with non-single crystal silicon as main materials thereof, and that includes a metal electrode, the photoelectric conversion layer, and a transparent electrode stacked in this order on a substrate, wherein a top cell which is the photoelectric conversion layer on the transparent electrode side and a cell of one or more layers on the metal electrode side relative to the top cell, are provided, and the method includes a process of simultaneously removing at least the two or more photoelectric conversion layers and the transparent electrode, using a laser with a wavelength having selective sensitivity with respect to the cell other than the top cell, from the transparent electrode side.

Specifically, the thin film solar cell is formed of a tandem stacked member having a top cell which is the photoelectric conversion layer on the transparent electrode side and a bottom cell on the metal electrode side, and the method includes a process of simultaneously removing the two photoelectric conversion layers and the transparent electrode, using a laser with a wavelength having selective sensitivity with respect to the bottom cell, from the transparent electrode side.

A band gap of an i layer of the bottom cell in the photoelectric conversion layer is smaller than that of an i layer of the top cell.
Further, the top cell i layer is made of amorphous silicon, and the i layer of the bottom cell of the photoelectric conversion layer is made of any one of amorphous silicon-germanium, microcrystalline silicon, and microcrystalline silicon-germanium.

Further, the thin film solar cell is formed of a triple stacked member having a top cell which is the photoelectric conversion layer on the transparent electrode side, a bottom cell on the metal electrode side, and an intermediate middle cell, and the method includes a process of simultaneously removing the three photoelectric conversion layers and the transparent electrode, using a laser with a wavelength having selective sensitivity with respect to at least one of the middle cell and the bottom cell, from the transparent electrode side.

The wavelength of the laser is in the range 600 to 900 nm, and preferably in the range 630 to 810 nm.
The laser used is one among an alexandrite laser, ruby laser, titanium sapphire laser, helium neon laser, krypton ion laser, and a semiconductor laser formed of AlGaAs.

On the other hand, a thin film solar cell of this invention, manufactured by this manufacturing method, is a substrate type solar cell that has a photoelectric conversion layer combining, in a thickness direction, two or more n, i, p junctions with non-single crystal silicon as main materials thereof, and that includes a metal electrode, the photoelectric conversion layer, and a transparent electrode stacked in this order on a substrate, wherein a top cell which is the photoelectric conversion layer on the transparent electrode side, and a cell of one or more layers on the metal electrode side relative to the top cell, are provided, and the thin film solar cell is configured such that the two or more photoelectric conversion layers including the top cell and the transparent electrode are simultaneously removed, using a laser generation device which generates laser light at a wavelength having selective sensitivity with respect to the cell other than the top cell, from the transparent electrode side.

Specifically, a configuration is provided in which, in the case of a tandem stacked member having a top cell which is the photoelectric conversion layer on the transparent electrode side and a bottom cell on the metal electrode side, by means of a laser device which generates laser light at a wavelength having selective sensitivity with respect to the bottom cell, when irradiation with laser light is performed from the transparent electrode side, the bottom cell is caused to absorb laser light, and fabrication by laser ablation is performed, the top cell of the upper layer is also blown away and removed, so that the two photoelectric conversion layers of the top cell and the bottom cell as well as the transparent electrode can be simultaneously removed.
Further, a band gap of an i layer of the bottom cell in the photoelectric conversion layer is smaller than that of an i layer of the top cell.
Further, the i layer of the top cell is made of amorphous silicon, and the i layer of the bottom cell of the photoelectric conversion layer is made of any one of amorphous silicon-germanium, microcrystalline silicon, and microcrystalline silicon-germanium.

In addition, a configuration is provided in which, in the case of a triple stacked member having a top cell which is the photoelectric conversion layer on the transparent electrode side, a bottom cell on the metal electrode side, and an intermediate middle cell, by means of a laser device which generates laser light at a wavelength having selective sensitivity with respect to at least one of the middle cell and the bottom cell, by performing irradiation with laser light from the transparent electrode side, the middle cell or bottom cell is caused to absorb laser light, and fabrication by laser ablation is performed, and other cells are also blown away and removed, so that the three photoelectric conversion layers of the top cell, the middle cell and the bottom cell, and also the transparent electrode, can be simultaneously removed.
Further, the laser generation device is configured so as to generate laser light in the laser wavelength range of 600 to 900 nm.

Further, as a two-step separation method, a first step in which the laser power is adjusted and the two layers of the photoelectric conversion layer and the transparent electrode are removed as described above, followed by a second step in which processing is performed to remove the metal electrode, is substantially easier to execute, and requires less processing time, than two-process methods as in the prior art in which the metal electrode is subjected to broad-width laser processing, and after depositing the photoelectric layers and transparent electrode, narrow-width laser processing is performed.
Further, in a two-step separation method of the prior art, there was a heat process for film deposition between the first laser processing and the second laser processing; but in a two-step separation method of this invention, there is no heat process for film deposition between the first step and the second step, and so there is the advantage that there is no thermal deformation of the film substrate. Further, it was necessary to execute non-parallel or nonlinear complex control of the second processing line in the prior art, but there is no thermal deformation in this invention, thereby parallel and linear processing is sufficient.
Further, with the film substrate fixed to one stage, processing can be performed twice, so that film positioning is also unnecessary. For the above reasons, time for film positioning is unnecessary, and processes can be shortened. Thus by means of this invention, the occurrence of leakage currents arising from transparent electrode processing of a substrate-structure solar cell can be suppressed, and production of an integrated type solar cell by all-laser processes, which had been difficult for substrate structures, becomes possible.

Further, in this invention, in order to selectively cause light absorption by the bottom cell, use of laser light at a wavelength of 600 to 900 nm, longer than the second harmonic of the YAG laser used for a-Si processing, and desirably at 630 to 810 nm, is effective.
If the wavelength is shorter than 600 nm, absorption of light in the a-Si cell becomes large, and selectivity cannot be maintained. And if the wavelength is longer than 900 nm, the light absorption coefficient of the bottom cell i layer becomes small, and processing is difficult. Further, the longer the wavelength, the larger the element of the heat processing, so that end face crystallization readily occurs.

As explained above, as a problem of substrate type devices, when processing is performed which causes the top cell below the transparent electrode to absorb laser light, the top cell crystallizes and becomes a source of leaks; hence this invention is characterized in that laser light is caused to be absorbed by the bottom cell or a middle cell other than the top cell, to perform processing such that the top cell is also blown away. Hence by means of a thin film solar cell and a method of manufacture thereof of this invention, crystallization of the bottom cell portion, which had arisen from transparent electrode processing in a substrate-structure solar cell, can be suppressed, and the unit-average leakage current can be suppressed. As a result, production of integrated type solar cells by all-laser processes, which previously had been difficult for substrate-structure devices, is made possible.

### BRIEF DESCRIPTION OF THE DRAWINGS

Fig. 1 shows the structure of a thin film solar cell of a first embodiment of the invention; Fig. 1A is a plane view; Fig. 1B is a cross-sectional view along A-A in Fig. 1A; and Fig. 1C is a cross-sectional view along B-B in Fig. 1A;
Fig. 2A to Fig. 2G are cross-sectional views showing a procedure for manufacture of the thin film solar cell in the first embodiment;
Fig. 3 is a graph showing the spectral sensitivity characteristic (collection efficiency) of the thin film solar cell of the first embodiment;
Fig. 4A to Fig. 4D are depth profiles of light absorption amounts for laser light in the first embodiment;
Fig. 5 is a graph showing the average light absorption ratios for bottom cells and top cells in the first embodiment;
Fig. 6 shows the structure of a thin film solar cell of a second embodiment of the invention; Fig. 6A is a cross-sectional view of the state before metal electrode processing;
and Fig. 6B is a cross-sectional view of the state after metal electrode processing;
Fig. 7A is a cross-sectional view of the state before metal electrode processing in the structure of a thin film solar cell of the prior art;
Fig. 7B is a cross-sectional view of the state after metal electrode processing in the structure of a thin film solar cell of the prior art;
Fig. 8 is a schematic diagram showing the structure of a thin film solar cell of the prior art;
Fig. 9 is a cross-sectional view showing the structure of a thin film solar cell of the prior art;
Fig. 10 shows a superstrate type a-Si solar cell; Fig. 10A is a profile of light absorption; and Fig. 10B is a schematic processing cross-sectional view.

### BEST MODE FOR CARRYING OUT THE INVENTION

Below, thin film solar cells and methods of manufacture thereof of the invention are explained in detail, based on embodiments and referring to the drawings.

### (First Embodiment)

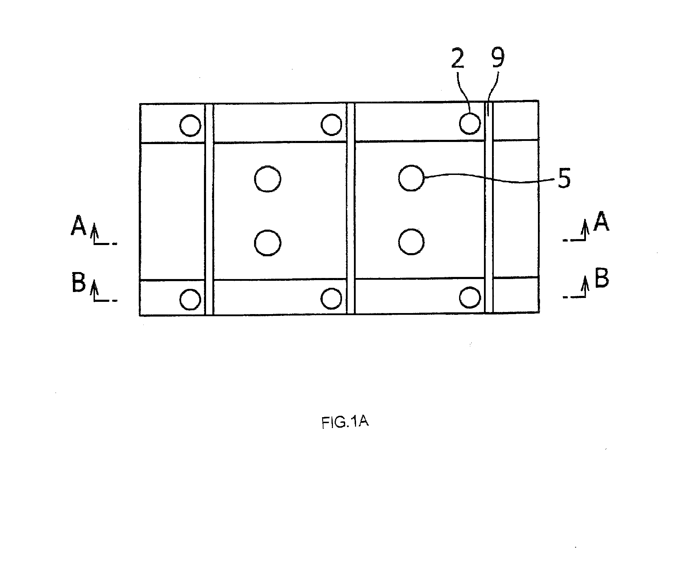

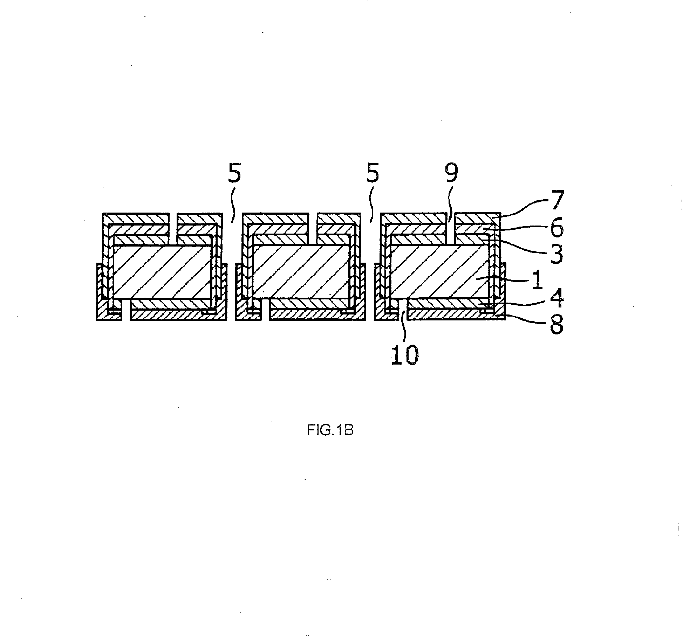

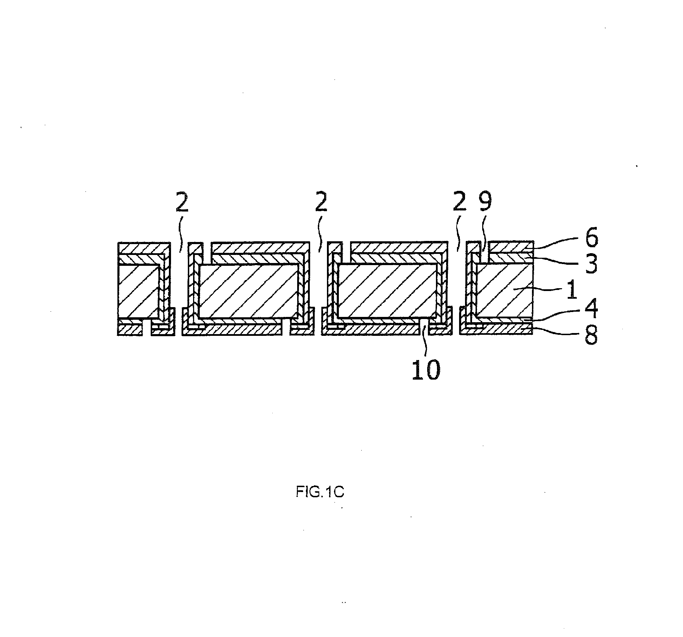

Fig. 1 shows a schematic cross-sectional view of the cell configuration of the thin film solar cell of a first embodiment of the invention. In the thin film solar cell of this first embodiment, at least a metal electrode, photoelectric conversion layer, and transparent electrode are formed in this order on an insulating film substrate; the method of manufacture is also explained below.
Specifically, in the substrate type solar cell of the first embodiment of the invention, as shown in Fig. 1, a metal electrode 3, photoelectric conversion layer 6, and transparent electrode 7 are formed on one face of a film substrate 1, and on the other face, sandwiching the substrate, are formed a first back-face electrode 4 and a second back-face electrode 8. The film layers deposited on the cell face and the back face are each separated into strip shapes by cell face-side processing lines 9 and back face-side processing lines 10, respectively.
Current flowing into the transparent electrodes 7 passes through collector holes 5 and is collected at the back-face electrodes 8, and series connection of unit cells is performed by means of series connection holes 2.

A stepping roll apparatus comprising a CVD chamber and a sputtering chamber is used as an apparatus to manufacture the thin film solar cell of the first embodiment of the invention. The electrode size in the CVD chamber is 12,000 cm², and six 1,720 cm² thin film solar cells can be manufactured per film deposition area on a film substrate 1 m in width.
Each chamber can be completely sealed while sandwiching the film substrate 1, and cells can be manufactured by a stepping roll film deposition method in which film deposition and transport are repeated in alternation.

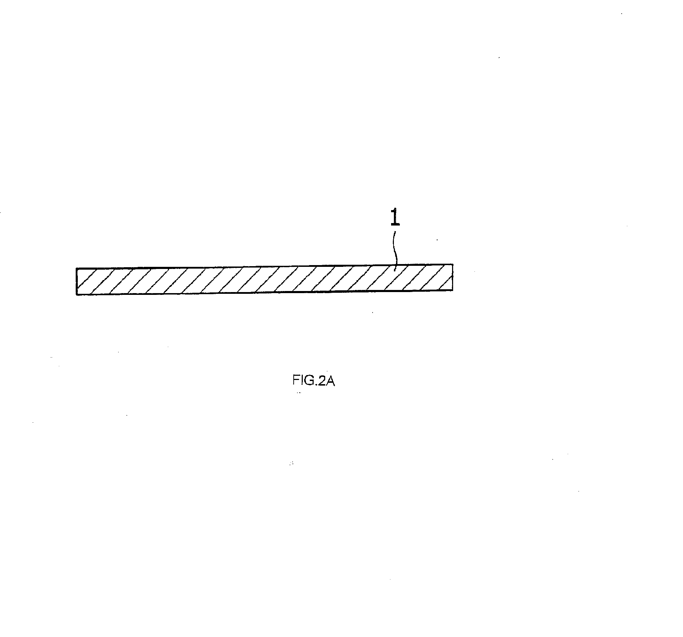

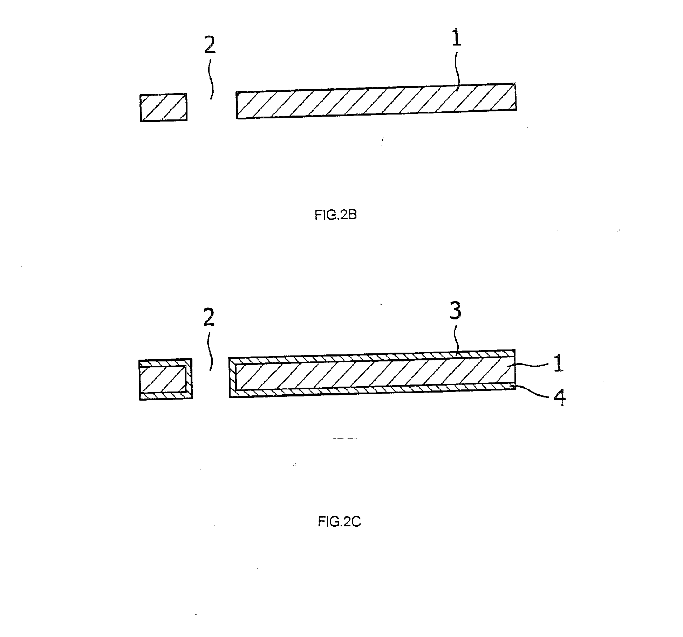

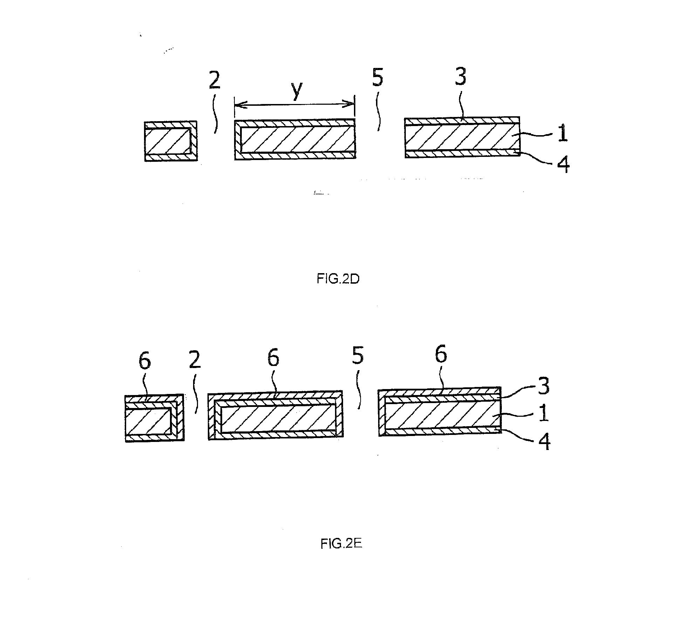

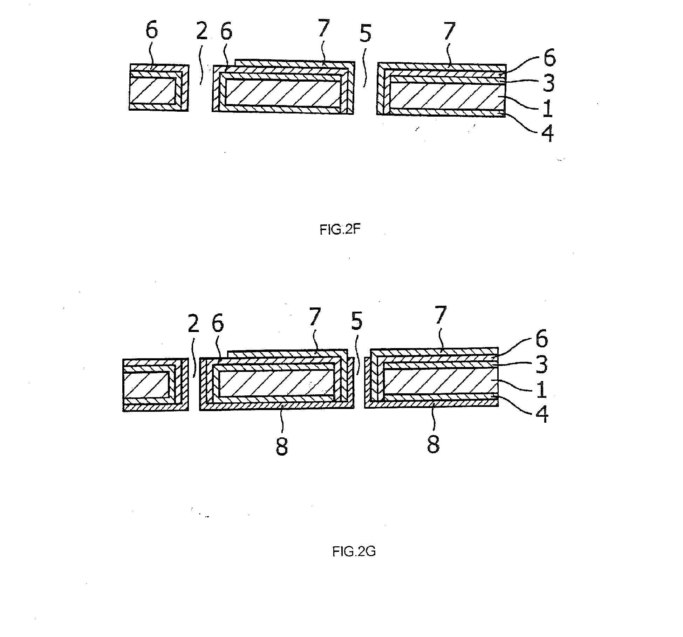

Below, a method for manufacturing solar cells using an apparatus for manufacture of substrate type thin film solar cells is explained, referring to Fig. 2.

### (Formation of first electrode)

First, as shown in Fig. 2A and Fig. 2B, series connection holes 2 are formed so as to penetrate both faces of the film substrate 1.
Next, as shown in Fig. 2C, on the two faces of the film substrate 1 are formed a metal electrode 3 (on one face) and a first back-face electrode 4 (on the other face). Then, as shown in Fig. 2D, series connection holes 2 and, at positions separated by a prescribed distance (y), collector holes 5 are formed.

### (Stepping roll film deposition)

Film substrate 1, onto and in which have been formed a metal electrode 3, first back-face electrode 4, series connection holes 2, and collector holes 5, is mounted, in roll form, on a stepping roll apparatus, and film deposition is performed. First, as shown in Fig. 2E, a plasma CVD method is used to deposit the photoelectric conversion layer 6.
The plasma CVD method is briefly explained. In the plasma CVD chamber are provided a high-frequency side electrode (cathode) and a ground-side electrode (anode); the raw material gas is supplied from a film deposition gas supply pipe with the flow rate adjusted to the ground-side electrode, and is supplied in shower form from the surface of the ground-side electrode.
The pressure within the vacuum container of the plasma CVD chamber is set to an arbitrary pressure, and when high-frequency power is applied from the high-frequency side electrode connected to a high-frequency power supply via a high-frequency power supply cable, plasma is generated between the high-frequency side electrode and the ground-side electrode, and the photoelectric conversion layer 6 is deposited on the film substrate 1.

The structure of a device trial-manufactured in this way is an a-Si/a-SiGe tandem cell. The bottom i layer and top i layer have film thicknesses of 120 nm and 200 nm respectively, and the respectively optical gaps are 1.5 eV and 1.8 eV. The Ge content in the a-SiGe layer is approximately 30%.

Next, as shown in Fig. 2F, the transparent electrode 7 is deposited in the sputtering chamber. At this time, as shown in Fig. 1, a line-shape mask is used in order that film does not adhere over the series connection holes 2. Then, as shown in Fig. 2G, the second back-face electrode 8 is deposited on the outside of the first back-face electrode 4.

### (Laser processing)

Next, the processed film substrate 1, wound into roll form, is mounted on a laser processing device, and the cell face-side processing line 9 and back face-side processing line 10 shown in Fig. 1 are formed by laser patterning.
Here, in order to investigate the effect of applying this invention to processing of the cell face-side line 9, three methods shown in Table 1 below, that is, Example of this invention, and Comparative Examples 1 and 2 which are examples of the prior art, were used in processing.

**Table 1**

| | First step | | | Second step | | |
|---|---|---|---|---|---|---|
| | Laser type | Wavelength (nm) | Fabrication width (µm) | Laser type | Wavelength | Fabrication width |
| Example | alexandrite | 755 | 100 | YAG 2nd harmonic | 532 | 100 |
| Comparative Example 1 | YAG 2nd harmonic | 532 | 400 | -- | -- | -- |
| Comparative Example 2 | YAG 2nd harmonic | 532 | 400 | YAG 2nd harmonic | 532 | 100 |

Comparative Example 1 is a method of batch processing to divide the three layers of the photoelectric conversion layer 6, transparent electrode 7, and metal electrode 3; Example and Comparative Example 2 are methods which perform division in two steps.
In Example and Comparative Example 2, which are two-step division processing methods, the laser power is adjusted, the two layers of the photoelectric conversion layer 6 and transparent electrode 7 in Fig. 1 are removed in the first step, and then the metal electrode 3 is removed in the second step.
From Table 1, in Example the laser in the first step was an alexandrite laser (wavelength 755 nm), and the laser in the second step was the second harmonic of a YAG laser (wavelength 532 nm).
In Example, after depositing in order the metal electrode 3, bottom cell and top cell of the photoelectric conversion layer 6, and transparent electrode 7, irradiation with laser light from the transparent electrode 7 was performed as the first step, in a laser ablation process realized by causing the bottom cell to absorb laser light, and the top cell and transparent electrode 7 were also blown away and removed; immediately thereafter, laser processing of the metal electrode 3 was performed in the second step.
In Comparative Example 2, after depositing the metal electrode 3, broad-width laser processing of the metal electrode in the first step is performed, and then, after depositing the photoelectric conversion layer 6 and transparent electrode 7, laser processing of the photoelectric conversion layer 6 and transparent electrode 7 using a narrow-width laser is performed in the second step.

The two-step division processing method of Example entails increased tasks compared with the batch division processing of Comparative Example 1, but crystallization of the end faces of the top cell is suppressed, and insulation of the transparent electrode 7 and metal electrode 3 is secured, so that thin film solar cells with little leakage and high efficiency are obtained. Further, comparing Example and Comparative Example 2, which are both two-step division processing methods, processing is substantially easier, and processing time is shorter, compared with broad-width laser processing of the metal electrode and depositing the photoelectric conversion layer rand transparent electrode, and then performing narrow-width laser processing to perform processing twice, as in Comparative Example 2 of the prior art. One reason for this is that, when processing is performed twice, between the first laser processing and the second laser processing, there was a heat process for film deposition; but in the two-step division method of this invention, there is no heat process for film deposition between the first step and the second step, so that there is no thermal deformation of the film substrate 1. Further, it was necessary to execute complex non-parallel or nonlinear control of the second-time processing line in the prior art, but there is no thermal deformation in this invention, thereby parallel and linear processing is sufficient. Further, the second processing can be performed with the film substrate 1 remaining fixed to one stage, so that positioning of the film substrate 1 is unnecessary.
Hence time to position the film substrate 1 is unnecessary, and the process is shortened.

### (Comparison of cell characteristics by trial manufacture)

Table 2 below compares representative cell characteristics of Example and Comparative Examples 1 and 2, using three types of trial-manufactured cells (68 in series, cell area 1,720 cm², aperture area 1,510 cm²) .

**Table 2**

| | Voc (V) | Isc (A) | FF | Pmax (W) | Unit cell average leakage current (A) |
|---|---|---|---|---|---|
| Example | 111 | 0.202 | 0.646 | 14.5 | 1.3 |
| Comparative Example 1 | 108 | 0.195 | 0.480 | 10.1 | 45 |
| Comparative Example 2 | 111 | 0.201 | 0.580 | 12.9 | 18 |

From the experimental results shown in Table 2, it is seen that the output is lowest for Comparative Example 1, using the three-layer batch division processing method, and that the output improves in the order of Comparative Example 2 and Example, which use two-step division processing methods.

Further, in Example of this invention, although the output is high, the unit average leakage current is held low relative to the improvement in output, so that the unit average leakage current is lowest. Hence in Example of this invention, the intended advantageous effects are exhibited, crystallization at the processed end portions is suppressed, and the unit average leakage current can be held low. Further, the reason for the higher unit average leakage current of the characteristics of Comparative Example 1 compared with Comparative Example 2 is thought to be the two phenomena of a greater extent of crystallization of the processed end portions, and an increase in alloying with the electrode, as results of processing with laser light at higher power.

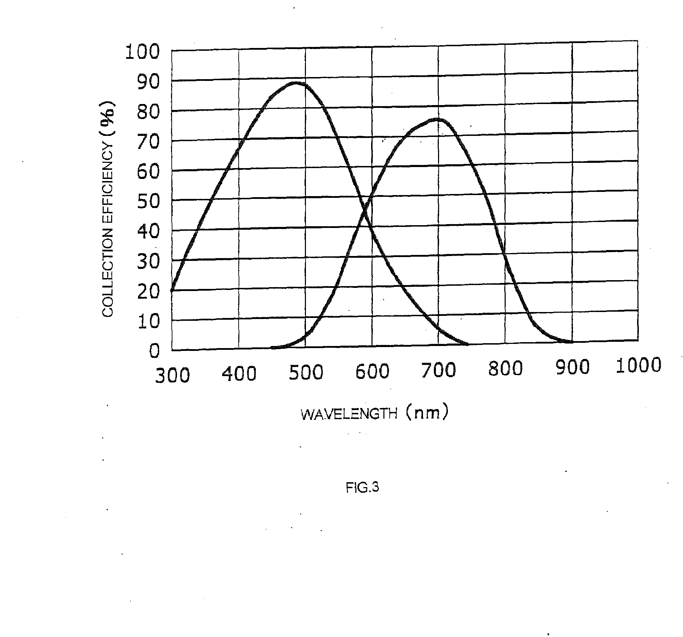

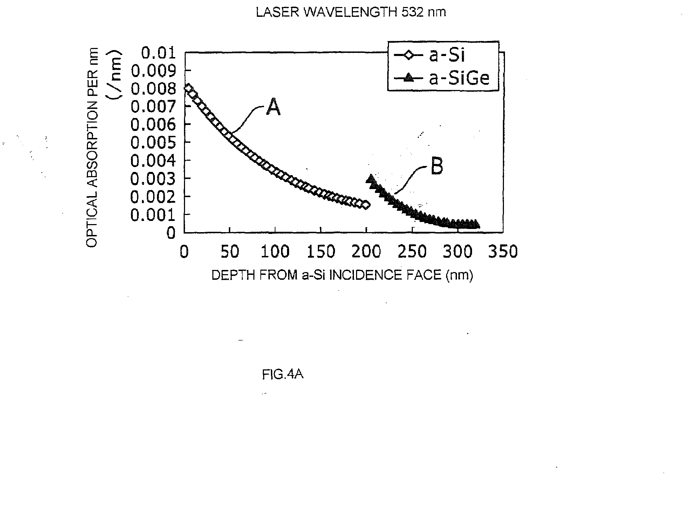

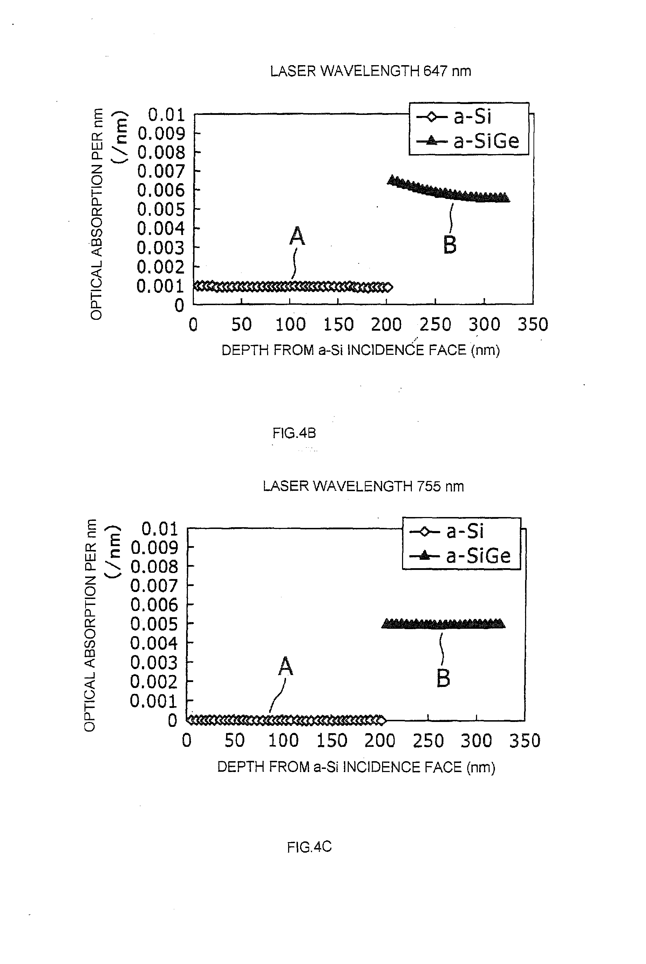

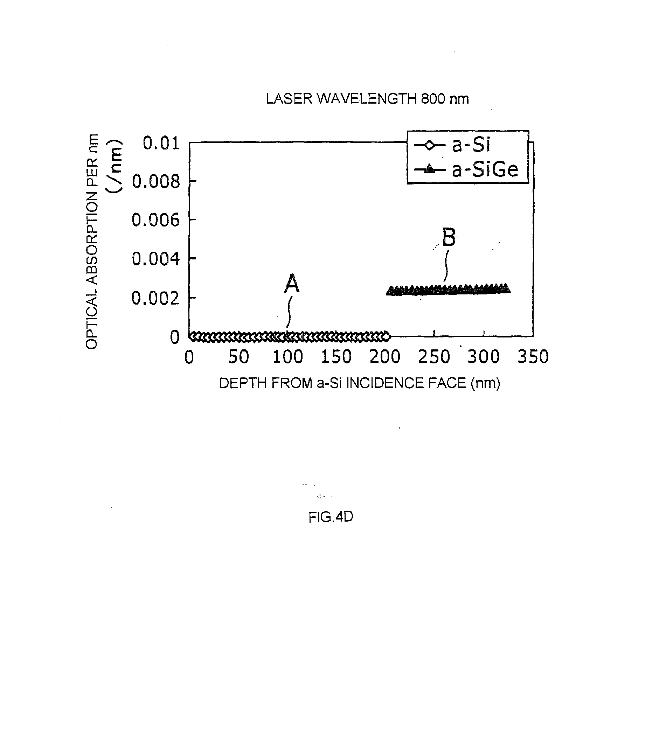

(Regarding the amount of absorption of laser light) Fig. 3 shows the spectroscopic sensitivity characteristics of the a-Si/a-SiGe tandem cells which were trial-manufactured and used in experiments. In Fig. 3, the short-wavelength side absorption characteristic with a peak near 490 nm is the top cell characteristic, and the long-wavelength side absorption characteristic with a peak near 700 nm is the bottom cell characteristic.
From Fig. 3, if the laser applied in the first step of Example of this invention is the alexandrite laser (wavelength 755 nm) of Table 1, then it is thought that selective absorption occurs in the bottom cell.
In order to further clarify this matter, simulations were performed to obtain depth profiles of absorption of laser light. The results appear in Fig. 4.

As shown in Fig. 4A to Fig. 4D, the lasers and laser light wavelengths are assumed to be: the second harmonic of a YAG laser, at 532 nm, a krypton ion laser at 647 nm, a ruby laser at 694 nm, an alexandrite layer at 755 nm, and an AlGaAs semiconductor laser at 800 nm.
The vertical axis in Fig. 4 indicates the light absorption per 1 nm when the incident laser light is 1. In Fig. 4, A indicates the top cell and B indicates the bottom cell.

From these results, in the case of 532 nm, corresponding to the second harmonic of the YAG laser, as shown in Fig. 4A, the fraction of light absorption along the vertical axis versus the depth from the a-Si incidence face along the horizontal axis is greater for the top cell A than for the bottom cell B. Further, the fraction of change in the light absorption versus the depth from the a-Si incidence face (horizontal axis) is seen to follow a profile which attenuates exponentially.
On the other hand, in the case of a krypton ion laser at 647 nm, as shown in Fig. 4B, the fraction of light absorption along the vertical axis versus the depth from the a-Si incidence face along the horizontal axis is greater for the bottom cell B than for the top cell A, and the fraction of change in the light absorption versus the depth from the a-Si incidence face (horizontal axis) is substantially constant.

That is, it is seen that as the wavelength of the laser light lengthens, the light absorption amount becomes greater for the bottom cell B than for the top cell A, and moreover the fraction of change of light absorption attenuates exponentially to become substantially constant. The results are as in Fig. 4C for the alexandrite laser at 755 nm and Fig. 4D for the AlGaAs semiconductor laser at 800 nm. Hence it is seen that the selective light absorption for the bottom cell B can always be increased, acting advantageously for selective light absorption of the bottom cell B.

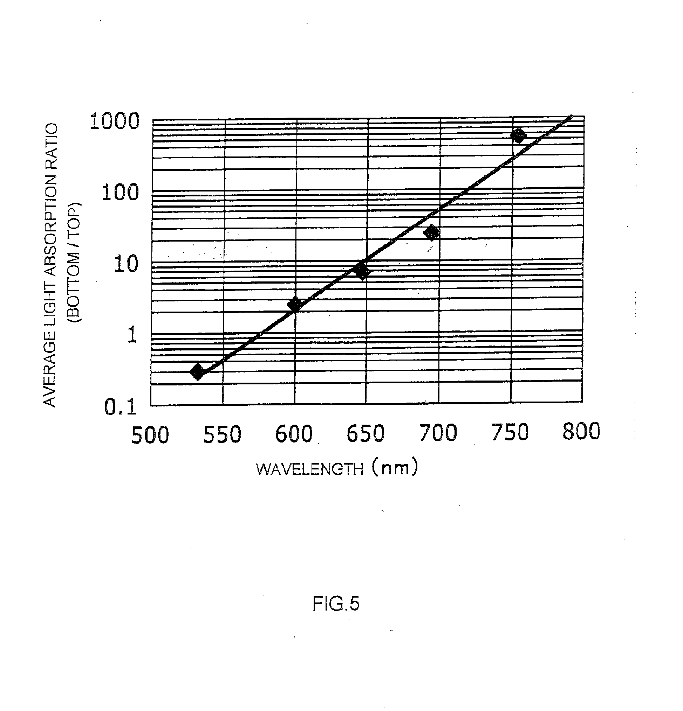

Fig. 5 derives the relation between average light absorption ratio (bottom cell/top cell) and wavelength, that is, the average light absorption for the bottom cell and the top cell, plotting the ratio thereof along the vertical axis. From these results, it is seen that the average light absorption ratio along the vertical axis is greater than 1 for wavelengths of 560 nm and longer. Judging from the results of another study, performed separately, of the relation between laser light intensity and crystallization, it is thought that if the average light absorption ratio is 2 or greater, selective light absorption processing is possible, and that an average light absorption ratio of 5 is still more preferable. Hence from the standpoint of the average light absorption ratio, it is thought that a reasonable laser light wavelength is 600 nm or greater, and preferably 630 nm or greater.

On the other hand, an element determining the upper limit of the laser light wavelength is the absolute value of the bottom cell light absorption. As is seen from the graph in Fig. 3 showing the spectroscopic sensitivity characteristic of the trial-fabricated a-Si/a-SiGe tandem cell, at wavelengths of 900 nm and higher there is no sensitivity, so that processing cannot be performed at wavelengths of 900 nm or longer. In the case of these a-Si/a-SiGe tandem cells, the wavelength upper limit is thought to be approximately 810 nm. If the Ge content of the a-SiGe tandem cell is increased, narrowing the band gap, then the absorption edge is shifted to longer wavelengths, so that when processing a triple cell with a Ge content of 40 to 50% in an a-SiGe tandem cell, the wavelength upper limit is thought to be approximately 900 nm. If microcrystalline silicon is used in the bottom cell, the processing wavelength upper limit is thought to be approximately 900 nm.

Further, in cases in which processability is a problem due to the wavelength, if the wavelength is longer than 900 nm, the heat processing element becomes more prominent and crystallization tends to occur; hence in order to avoid effects of heat processing, the wavelength must not be made to exceed 900 nm.
Hence it is thought that a laser light wavelength of 900 nm or lower, and preferably 810 nm or lower, is reasonable.

### (Second Embodiment)

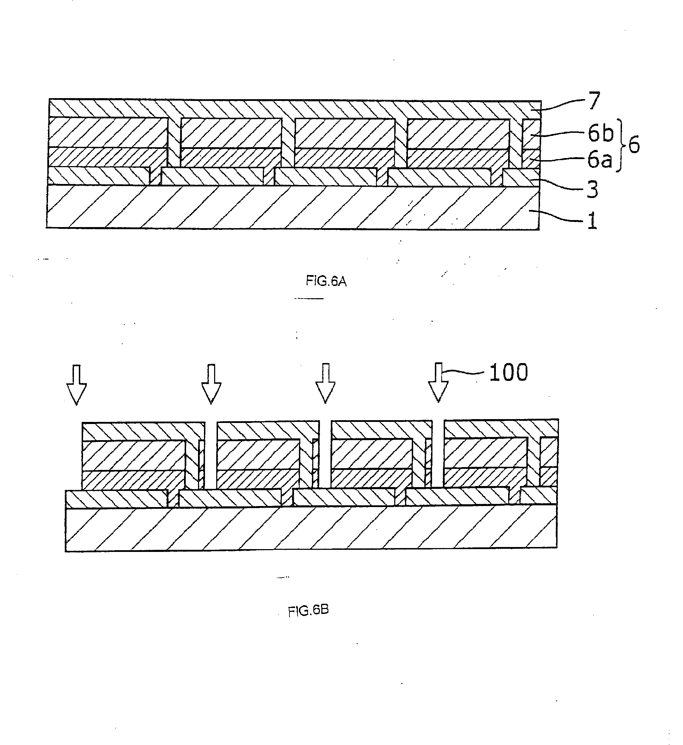

A second embodiment of the invention concerns a method for manufacturing a substrate structure thin film solar cell in which serial connections are made without using series connection holes 2, collector holes 5 and other holes. Fig. 6 shows the structure of the thin film solar cell of the second embodiment of the invention; Fig. 6A is a cross-sectional view of the state before metal electrode processing, and Fig. 6B is a cross-sectional view of the state after metal electrode processing; these schematic diagrams show the transparent electrode 7 before and after processing.

In the state shown in Fig. 6A, the metal electrode 3 and photoelectric conversion layer 6 are both deposited on the film substrate 1, and formation by laser patterning is performed. Then, the transparent electrode 7 is formed on these layers. Here, the photoelectric conversion layer 6 of this embodiment has a tandem structure with an a-SiGe bottom cell 6a and an a-Si top cell 6b; the lower portion of the transparent electrode 7 is formed so as to reach the metal electrode 3 via strip-shape cut-away portions of the photoelectric conversion layer 6.

In this state, as shown in Fig. 6B, irradiation from above the transparent electrode 7 with laser light of wavelength 600 to 900 nm, and still more desirably 630 to 810 nm, is performed.
By this means, selective absorption in the bottom cell 6a is realized, and by blowing away using laser light, the top cell 6b and transparent electrode 7 can be simultaneously removed.

Thus by means of the second embodiment of the invention, crystallization of the end faces of the top cell 6b is suppressed, so that insulation of the transparent electrode 7 and metal electrode 3 in these portions is secured. Hence a thin film solar cell with little leakage and high efficiency is obtained.

In the above, embodiments of the invention have been described, but the invention is not limited to the embodiments described above, and various modifications and alterations are possible based on the technical concept of the invention.
For example, this invention is not limited to a tandem stacked member having a top cell 6b on the side of the transparent electrode 7 and a bottom cell 6a on the side of the metal electrode 3, but can also be applied to a triple stacked member having a middle cell intermediate between a top cell 6b and a bottom cell 6a.

### EXPLANATION OF REFERENCE NUMERALS

- 1: Film substrate
- 2: Series connection hole
- 3: Metal electrode
- 4: First back-face electrode
- 5: Collector hole
- 6: Photoelectric conversion layer
- 6a: Bottom cell
- 6b: Top cell
- 7: Transparent electrode
- 8: Second back-face electrode
- 9: Cell face-side processing line
- 10: Back face-side processing line

## Claims

1. A method for manufacturing a thin film solar cell, which is a substrate type solar cell that has a photoelectric conversion layer combining, in a thickness direction, two or more n, i, p junctions with non-single crystal silicon as main materials thereof, and that comprises a metal electrode, the photoelectric conversion layer, and a transparent electrode stacked in this order on a substrate, **characterized in that**:
a top cell which is the photoelectric conversion layer on the transparent electrode side, and a cell of one or more layers on the metal electrode side relative to the top cell, are provided, and the method comprises a step of:
simultaneously removing at least the two or more photoelectric conversion layers and the transparent electrode, using a laser with a wavelength having selective sensitivity with respect to the cell other than the top cell, from the transparent electrode side.

2. The method for manufacturing a thin film solar cell according to Claim 1, **characterized in that** the thin film solar cell is formed of a tandem stacked member having a top cell which is the photoelectric conversion layer on the transparent electrode side and a bottom cell on the metal electrode side, and
the method comprises a step of simultaneously removing the two photoelectric conversion layers and the transparent electrode, using a laser with a wavelength having selective sensitivity with respect to the bottom cell, from the transparent electrode side.

3. The method for manufacturing a thin film solar cell according to Claim 2, **characterized in that** in the photoelectric conversion layer, a band gap of an i layer of the bottom cell is smaller than that of an i layer of the top cell.

4. The method for manufacturing a thin film solar cell according to Claim 2 or 3, **characterized in that** the i layer of the top cell of the photoelectric conversion layer is made of amorphous silicon, and that the i layer of the bottom cell of the photoelectric conversion layer is made of any one of amorphous silicon-germanium, microcrystalline silicon, and microcrystalline silicon-germanium.

5. The method for manufacturing a thin film solar cell according to Claim 1, **characterized in that** the thin film solar cell is formed of a triple stacked member having a top cell which is the photoelectric conversion layer on the transparent electrode side, a bottom cell on the metal electrode side, and an intermediate middle cell, and
the method comprises a step of simultaneously removing the three photoelectric conversion layers and the transparent electrode, using a laser with a wavelength having selective sensitivity with respect to at least one of the middle cell and the bottom cell, from the transparent electrode side.

6. The method for manufacturing a thin film solar cell according to any one of Claims 1 to 5, **characterized in that** the wavelength of the laser is in the range 600 to 900 nm.

7. The method for manufacturing a thin film solar cell according to any one of Claims 1 to 4, **characterized in that** the laser used is any one of an alexandrite laser, ruby laser, titanium sapphire laser, helium neon laser, krypton ion laser, and a semiconductor laser formed of AlGaAs.

8. A thin film solar cell, which is a substrate type solar cell that has a photoelectric conversion layer combining, in a thickness direction, two or more n, i, p junctions with non-single crystal silicon as main materials thereof, and that comprises a metal electrode, the photoelectric conversion layer, and a transparent electrode stacked in this order on a substrate, **characterized in that**:
a top cell which is the photoelectric conversion layer on the transparent electrode side, and a cell of one or more layers on the metal electrode side relative to the top cell, are provided, and
the thin film solar cell is configured such that the two or more photoelectric conversion layers and the transparent electrode are simultaneously removed, using a laser generation device which generates laser light at a wavelength having selective sensitivity with respect to the cell other than the top cell, from the transparent electrode side.

9. The thin film solar cell according to Claim 8, **characterized in that** the thin film solar cell is formed of a tandem stacked member having a top cell which is the photoelectric conversion layer on the transparent electrode side and a bottom cell on the metal electrode side, and
the thin film solar cell is configured such that the two photoelectric conversion layers and the transparent electrode are simultaneously removed, using a laser generation device which generates laser light at a wavelength having selective sensitivity with respect to the bottom cell, from the transparent electrode side.

10. The thin film solar cell according to Claim 9, **characterized in that** in the photoelectric conversion layer, a band gap of an i layer of the bottom cell is smaller than that of an i layer of the top cell.

11. The thin film solar cell according to Claim 9 or 10, **characterized in that** the i layer of the top cell of the photoelectric conversion layer is made of amorphous silicon, and that the i layer of the bottom cell of the photoelectric conversion layer is made of any one of amorphous silicon-germanium, microcrystalline silicon, and microcrystalline silicon-germanium.

12. The thin film solar cell according to Claim 8, **characterized in that** the thin film solar cell is formed of a triple stacked member having a top cell which is the photoelectric conversion layer on the transparent electrode side, a bottom cell on the metal electrode side, and an intermediate middle cell, and
the thin film solar cell is configured such that the three photoelectric conversion layers and the transparent electrode are simultaneously removed, using a laser generation device which generates laser light at a wavelength having selective sensitivity with respect to at least one of the middle cell and the bottom cell, from the transparent electrode side.

13. The thin film solar cell according to any one of Claims 8 to 12, **characterized in that** the laser generation device is configured to generate laser light in the wavelength range 600 to 900 nm.
